Europäisches Patentamt

European Patent Office

Office européen des brevets

(11) Numéro de publication: **0 244 299 B1**

## FASCICULE DE BREVET EUROPEEN

(45) Date de publication de fascicule du brevet:
**17.07.91**

(51) Int. Cl.5: **H01L 31/10**

(21) Numéro de dépôt: **87400893.1**

(22) Date de dépôt: **17.04.87**

(54) **Photodiode PIN réalisée à partir de semiconducteur amorphe.**

(30) Priorité: **22.04.86 FR 8605806**

(43) Date de publication de la demande:
**04.11.87 Bulletin 87/45**

(45) Mention de la délivrance du brevet:
**17.07.91 Bulletin 91/29**

(84) Etats contractants désignés:
**DE GB NL**

(56) Documents cités:
**EP-A- 0 133 342**
**GB-A- 2 107 927**
**US-A- 4 278 474**

**PATENT ABSTRACTS OF JAPAN, vol. 9, no. 15 (E-291)[1738], 22 janvier 1985; & JP-A-59 163 878**

**APPLIED PHYSICS LETTERS, vol. 45, no. 1, 1er juillet 1984, pages 13-15, American Institute of Physics, Woodbury, US; D.A.B. MILLER et al.: "Novel hybrid optically bistable switch: the quantum well self-electro-optic effect device"** .

(73) Titulaire: **THOMSON-CSF**
**51, Esplanade du Général de Gaulle**
**F-92800 Puteaux(FR)**

(72) Inventeur: **Henry, Yves**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

APPLIED PHYSICS LETTERS, vol. 45, no. 11, 1er décembre 1984, pages 1193-1195, American Institute of Physics, Woodbury, US; F. CAPASSO et al.: "Pseudo-quaternary galnAsP semiconductors: A new Ga0.47In0.53As/InP graded gap superlattice and its applications to avalanche photodiodes"

LASER FOCUS, vol. 20, no. 7, juillet 1984, pages 84,86,88,90,92,94,96,98,100,101, Newton, Massachussetts, US; F. CAPASSO: "Multilayer avalanche photodiodes and solid-state photomultipliers"

APPLIED PHYSICS LETTERS, vol. 40, no. 1, 1er janvier 1982, pages 38-40, American Institute of Physics, New York, US; F. CAPASSO et al.: "Enhancement of electron impact ionization in a superlattice: A new avalanche photodiode with a large ionization rate ratio"

APPLIED PHYSICS LETTERS, vol. 44, no. 1, 1er janvier 1984, pages 16-18, American Institute of Physics, Woodbury, US; T.H. WOOD et al.: "High-speed optical modulation with GaAs/GaAlAs quantum wells in a p-i-n diode structure"

## Description

La présente invention concerne une photodiode PIN réalisée à partir de semiconducteur amorphe.

Il est connu de réaliser des photodiodes PIN en silicium amorphe.

Le silicium amorphe est utilisé, de préférence au silicium cristallin, pour diverses raisons. L'une de ces raisons est que le silicium amorphe a des caractéristiques différentes de celles du silicium cristallin, et qui dans certaines utilisations sont plus intéressantes.

Ainsi, la largeur de bande interdite du silicium cristallin est de 1,1 e-V à 1,15 e-V, alors que celle du silicium amorphe est de 1,6 à 1,75 e-V. Le silicium cristallin assure la détection dans le visible sur une épaisseur très grande devant celle du silicium amorphe (quelques dizaines de micromètres contre 0,5 micromètre). Une autre raison de l'utilisation du silicium amorphe de préférence au silicium cristallin est qu'il est possible de déposer rapidement, sur un matériau bon marché tel que du verre, de grandes surfaces de silicium amorphe. Au contraire, on ne sait déposer le silicium cristallin que sur de faibles surfaces et cela exige des températures beaucoup plus élevées.

Du fait de sa nature désordonnée, au sens cristallographique du terme, le silicium amorphe contient un grand nombre de défauts. Ces défauts introduisent des états dits localisés à l'intérieur de la bande interdite. On utilise généralement du silicium amorphe hydrogéné qui est une variante contenant de l'hydrogène, lequel en se fixant sur les liaisons pendantes, c'est-à-dire non satisfaites, des atomes de silicium, diminue la densité des défauts et améliore la qualité du silicium amorphe.

Le silicium amorphe est utilisé notamment dans les cellules solaires montées par exemple sur les calculatrices et dans les barrettes de détecteurs, destinées à la télécopie.

Les photodiodes PIN en silicium amorphe qui sont connues présentent de nombreux inconvénients. Parmi, ces inconvénients on peut citer le fait que les couches de type P et de type N sont obtenues par dopage, ce qui accroît le nombre de défauts du silicium amorphe de façon importante, puisque le nombre de défauts est multiplié par un facteur de l'ordre de 100.

Un autre inconvénient est que pour obtenir du silicium amorphe de type P ou de type N , il faut ajouter au silane dont la décomposition thermique donne du silicium amorphe, une forte concentration, de l'ordre de 5000 à 10000 ppm, de gaz dopant, tel que le diborane pour l'obtention du type P et la phosphine pour l'obtention du type N . Or le diborane et la phosphine sont des gaz extrêmement dangereux, à forte concentration. La dose limite admissible par l'organisme humain est de 0,1 ppm pour le diborane et de 0,3 ppm pour la phosphine, ce qui impose des mesures de sérurité très onéreuses pour éviter les fuites et traiter les effluents des machines de dépôt.

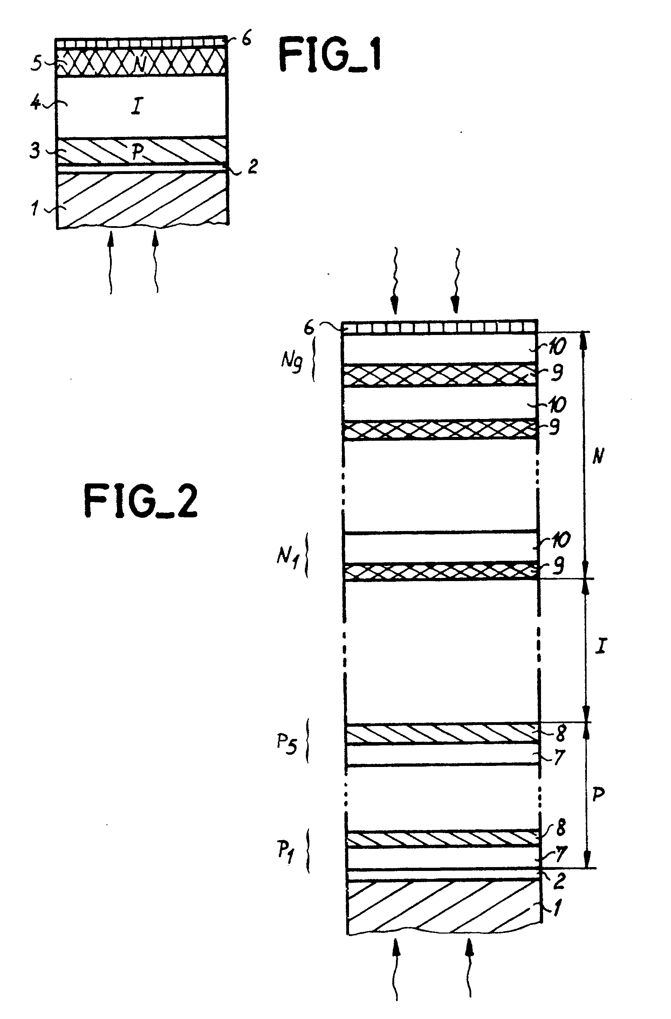

Un autre inconvénient des photodiodes PIN en silicium amorphe connues est qu'il n'est pas possible d'envoyer le rayonnement à détecter indifféremment sur le côté N ou sur le côté P de la photodiode. Sur la figure 1, on a représenté un mode de réalisation où le rayonnement arrive sur le côté P. Si l'on veut éclairer le côté N, cela est possible mais nécessite de modifier la structure de la photodiode afin de diminuer l'épaisseur de la couche de type N pour la rendre moins absorbante. Signalons qu'un inconvénient supplémentaire d'un fort dopage est qu'il rend les matériaux plus absorbants.

Un dernier inconvénient des photodiodes PIN en silicium amorphe connues est qu'elles présentent une capacité élevée qui peut limiter leur emploi dans des structures photosensibles matricielles, constituées d'éléments photosensibles interconnectés, où chaque élément photosensible comporte une photodiode PIN. Ces structures photosensibles peuvent être utilisées pour détecter tout type de rayonnement, et par exemple un rayonnement X lorsque la structure photosensible est précédée par un scintillateur.

La présente invention concerne des photodiodes PIN réalisées à partir de semiconducteur amorphe qui, selon les modes de réalisation, permettent de supprimer certains ou la totalité des inconvénients énoncés précédemment. Elles utilisent les effets quantiques des super-réseaux semiconducteurs cristallins dans la forme particulière qu'ils prennent lorsque le matériau est un semiconducteur amorphe.

Ces super-réseaux sont décrits de manière théorique dans l'article de Inan CHEN, paru dans "Physical review B", vol. 32, n° 2, 15 juillet 1985, page 885. Une photodiode comprenant une zone de couches semiconductrices alternées formant un super-réseau est décrite dans GB-A-2107927. Il faut noter que si, en français, le terme "super-réseau" est le plus utilisé par les Spécialistes, en anglais, c'est le terme "multilayers" qui est employé.

Il existe deux grandes catégories de super-réseaux. La première est celle des super-réseaux de composition dans laquelle il y a superposition de couches de nature physico-chimique différente, dopées ou non. La seconde est celle des super-réseaux de dopage dans laquelle il y a superposition de couches de même nature physico-chimique, mais dopées alternativement de type P et de type N.

Un dispositif semiconducteur comportent un super-réseau formé de couches semiconductrices et isolantes alternées est décrit dans EP-A-0133342.

La présente invention concerne une photodiode PIN, réalisée à partir de semiconducteur amorphe, comportant trois couches superposées qui sont une couche de type P, une couche intrinsèque et une couche de type N, caractérisée en ce qu'au moins l'une de ces couches est constituée par un super-réseau de composition, comportant des couches superposées de semi-conducteur amorphe et d'isolant, non dopées, et en ce que le ou les autres couches sont réalisées en semiconducteur amorphe.

Selon l'invention, on utilise des super-réseaux de composition constitués par la superposition de couches de nature physico-chimique différents, et non dopées, pour réaliser au moins l'une des couches de type P, de type N, ou intrinsèque, des photodiodes PIN.

Les photodiodes PIN selon l'invention, dans le cas où leurs couches P et N sont réalisées par des super-réseaux, ne nécessitent plus lors de leur fabrication l'utilisation de gaz dopants. En conséquence, les installations nécessaires à leur fabrications sont simplifiées. De plus, les couches de type P ou N obtenues sont de meilleure qualité puisqu'il n'y a plus de dopage, générateur de nombreux défauts.

Les couches P et N réalisées par des super-réseaux sont plus transparentes que celles obtenues par dopage. Les photodiodes PIN selon l'invention peuvent donc être éclairées indifféremment par leur côté P ou leur côté N, ou par les deux côtés simultanément.

L'utilisation d'un super-réseau pour réaliser la couche intrinsèque permet de diminuer la capacité des photodiodes PIN qui peuvent donc être utilisées dans des dispositifs matriciels. Il faut noter qu'il est également possible, si on le souhaite, d'augmenter la capacité des photodiodes PIN du fait de l'utilisation d'un super-réseau pour réaliser la couche intrinsèque.

D'autres objets, caractéristiques et résultats de l'invention ressortiront de la description suivante, donnée à titre d'exemple non limitatif et illustrée par les figures annexées qui représentent:
- la figure 1, une vue en coupe d'une photodiode PIN en silicium amorphe selon l'Art Antérieur;
- les figures 2 et 5, des vues en coupe de deux modes de réalisation de photodiodes PIN à super-réseaux selon l'invention;
- les figures 3a et 3b, 4a et 4b et 6a et 6b, des schémas expliquant le fonctionnement des photodiodes des figures 2 et 5.

Sur les différentes figures, les mêmes repères désignent les mêmes éléments, mais, pour des raisons de clarté, les cotes et proportions des divers éléments ne sont pas respectées.

La figure 1 représente une vue en coupe d'un mode de réalisation d'une photodiode selon l'art antérieur.

Cette photodiode est constituée par la superposition des couches suivantes:
- un substrat en verre 1, qui reçoit la lumière à analyser, représentée symboliquement par des flèches ondulées;
- une couche conductrice transparente 2, dont l'épaisseur peut varier entre 50 et 200 nm;
- une couche 3 de type P, en silicium amorphe hydrogéné ou en carbure de silicium amorphe hydrogéné P, qui permet un meilleur transfert des photons bleus que le silicium- L'épaisseur de la couche 3 peut varier entre 10 et 30 nm. La conductivité de type P est généralement obtenue par dopage au bore;
- une couche intrinsèque I qui porte la référence 4, en silicium amorphe hydrogéné non dopé, qui est la zone où s'étend le champ électrique servant à séparer les porteurs de charges créés par l'absorption du flux de lumière à analyser. L'épaisseur de la couche intrinsèque 4 varie entre 500 et 1000 nanomètres ;
- une couche 5, en silicium amorphe hydrogéné de type N. L'épaisseur de cette couche varie de 30 à 50 nm. La conductivité de type N est généralement obtenue par dopage au phosphore ;
- une couche conductrice 6, généralement métallique.

La figure 2 représente une vue en coupe d'un mode de réalisation d'une photodiode PIN selon l'invention.

Ce mode de réalisation diffère de celui de la figure 1 car les couches de type P et de type N sont réalisées par deux super-réseaux de composition, constitués par la superposition de couches, non dopées, de semiconducteur amorphe et d'isolant se comportant respectivement comme un matériau de type P, et comme un matériau de type N.

La couche intrinsèque I est comme dans le cas de la figure 1 relative à l'Art Antérieur constituée de semiconducteur amorphe massif.

La couche de type P est constituée par la superposition de couches 7, en silicium amorphe hydrogéné, ce qui s'écrit a-Si : H, dont l'épaisseur est d'environ 4nm et de couches 8, en isolant amorphe hydrogéné, chargé positivement, par exemple, de formule a -Si $O_x$ : H, avec $x \leq 2$, car le matériau n'est jamais totalement stoechiométrique, l'épaisseur des couches 8 est d'environ 2 nm. On appelle période la superposition de deux couches 7 et 8. Le super-réseau constituant la couche de type P comporte 5 périodes, référencées $P_1$ à $P_5$. L'isolant utilisé peut être amorphe ou cristallin et dans ce cas x = 2. Etant donné le procédé de fabrication des super-réseaux dont il est question dans l' invention, l'isolant obtenu est amorphe. La fabrication se fait par décharge luminescente ("glow discharge").

Après la couche de type P, on trouve la couche intrinsèque désignée par la référence I. Elle est constituée par environ 500 nm de silicium amorphe hydrogéné a - Si : H.

Après la couche intrinsèque, il y a la couche de type N constituée par un super-réseau de neuf périodes, portant les références $N_1$ à $N_9$. Chaque période est constituée par une couche 9 d'isolant chargé négativement, par exemple, de formule a -$Si_y N_x$ : H, avec $x \leq 4$ et $y \leq 3$, d'environ 2nm d'épaisseur et par une couche 10 en silicium amorphe hydrogéné a - Si : H.

On choisit les épaisseurs des couches entrant dans la composition des super-réseaux, ainsi que le nombre de leurs périodes en fonction de la conductivité recherchée pour les couches de type P, N ou I à réaliser et en fonction de la transparence recherchée pour les photodiodes. Il faut au minimum trois couches superposées, une d'isolant, une de semiconducteur et une d'isolant pour obtenir un super-réseau de composition.

L'épaisseur des couches isolantes doit être suffisamment faible pour que les porteurs de charges générés dans la zone de charge d'espace du silicium intrinsèque puissent franchir par effet Tunnel les barrières de potentiel constituées par l'isolant.

En ce qui concerne la nature des couches isolantes, non dopées, il est clair que l'on n'est pas limité aux exemples donnés dans la description de la figure 2. En plus des isolants a - Si Ox : H et a - $Si_y N_x$ : H, on peut utiliser des isolants, amorphes ou non, hydrogénés ou non, de formule $Al_x O_y$, avec $x \leq 2$ et $y \leq 3$, (isolant chargé négativement), Al N, Al ON, Si ON, $SiC_x$, avec $x > 0,5$ (isolant chargé positivement)....

De même, en ce qui concerne le semiconducteur amorphe utilisé pour réaliser les super-réseaux, on n'est pas limité au silicium, et des semiconducteurs amorphes tels que par exemple des matériaux du type III - V, comme l'arséniure de gallium, du germanium, des chalcogénures, par exemple, ceux comportant plusieurs éléments de la colonne 2 du tableau périodique, peuvent aussi être utilisés.

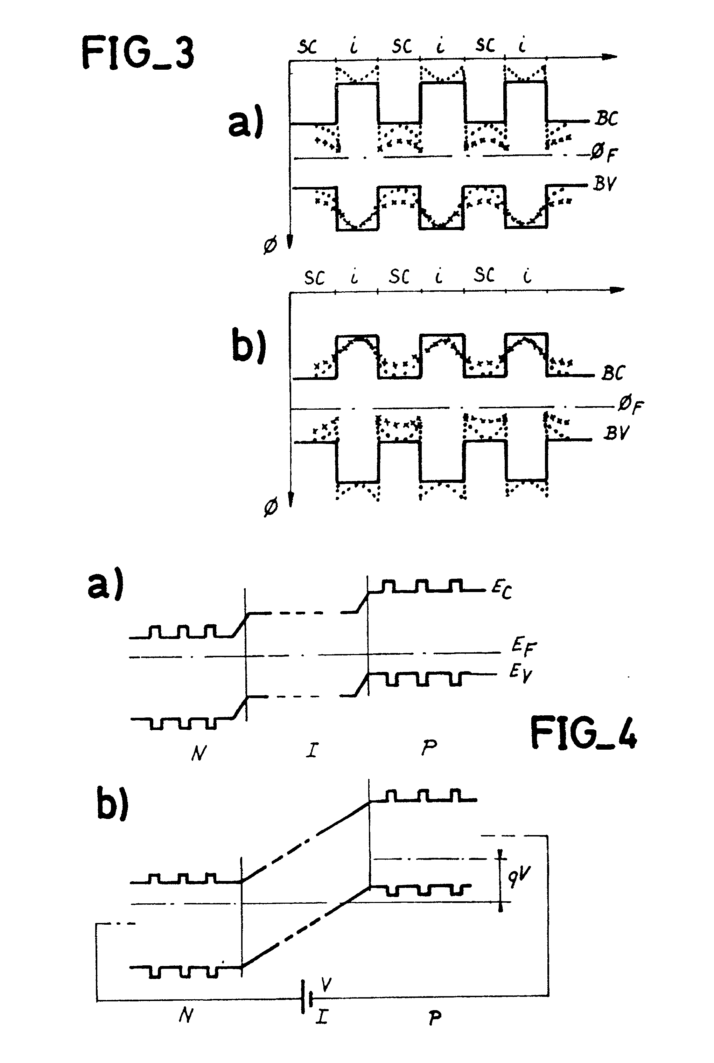

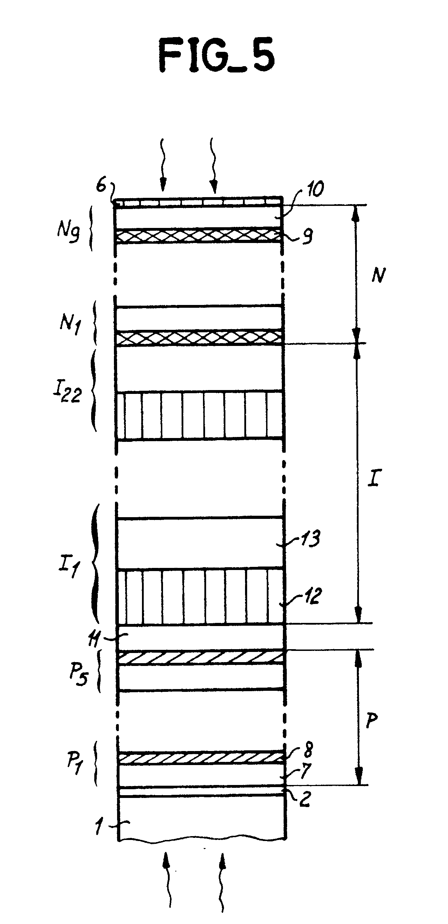

Les figures 3a et 3b et 4a et 4b illustrent le fonctionnement des super-réseaux utilisés dans le mode de réalisation de la figure 2.

Sur les figures 3a et 3b, on a représenté en ordonnée les potentiels $\phi$ et en particulier, on a indiqué la position de la bande de conduction BC, de la bande de valence BV, et la position du niveau de Fermi $\phi_F$.

Sur ces figures, on a représenté en abscisse la succession de couches d'isolant i et de couches de semiconducteur SC.

Les potentiels représentés en trait plein correspondent à la position de la bande de conduction et de la bande de valence dans le semiconducteur et dans l'isolant si l'on ne tient pas compte des modifications apportées aux potentiels par la présence des isolants.

On a représenté en pointillés comment ces potentiels étaient modifiés du fait de la présence des isolants.

Si l'on considère des couches isolantes dont l'épaisseur ne varie pas, les potentiels sont représentés par une succession de points, dans le cas de couches en semiconducteur amorphe de forte épaisseur et par une succession de croix, dans le cas de couches en semiconducteur amorphe de faible épaisseur.

La figure 3a correspond au cas d'un isolant chargé négativement, ce qui est le cas du $Si_y N_x$ hydrogéné amorphe, qui permet d'obtenir un super-réseau dont le fonctionnement équivaut à celui d'une couche de type N.

La figure 3b correspond au cas d'un isolant chargé positivement, ce qui permet d'obtenir un super-réseau dont le fonctionnement équivaut à celui d'une couche de type P, ce qui est le cas du Si $O_x$ hydrogéné amorphe.

Les super-réseaux amorphes, qui se comportent comme un matériau de type P ou de type N, consistent donc en une alternance de couches i d'isolants à largeur de bande interdite élevée et de couches semiconductrices amorphes SC à largeur de bande interdite plus faible, comme on peut le voir sur les figure 3a et 3b.

Comme dans le cas des super-réseaux cristallins, il y a des discontinuités dans la bande interdite faisant intervenir des barrières et des puits de potentiel.

Dans le cas des alternances de couches décrites, où chaque période comporte une couche d'isolant et une couche de SC amorphe, la présence des isolants modifie les raccordements des bandes. Les isolants sont connus pour être des porteurs de charges à des densités surfaciques généralement comprises entre $10^{11}$ et $10^{12}$ charges/$cm^2$. Ces charges peuvent être positives ou négatives selon la nature de l'isolant. Elles sont injectées dans le semiconducteur adjacent.

Dans le cas où l'isolant est chargé négativement, comme sur la figure 3a, le potentiel s'abaisse du côté de l'isolant et augmente du côté du semiconducteur. Au niveau de la bande de conduction, cela rend le puits de potentiel plus profond, et cela d'autant plus que l'épaisseur du semiconducteur est plus faible. La résistivité diminue donc. Au niveau de la bande de valence, le puits de potentiel devient moins profond.

Pour une épaisseur des couches de semiconducteur inférieure à 10 nm, le potentiel dans ces couches est à peu près constant sur toute leur épaisseur.

Dans le cas d'un isolant chargé positivement, comme sur la figure 3b, on constate que les modifications de potentiel qui atteignent dans le cas de la figure 3a la bande de conduction atteignent dans ce cas, la bande de valence, et vice-versa.

La position du niveau de Fermi $\phi_F$ est fixée par l'isolant. Pour des épaisseurs inférieures à 10 nm, le niveau de Fermi $\phi_F$ se situe à environ 0,175 eV du bord de la bande de conduction dans le cas d'un super-réseau utilisant un isolant chargé négativement et à 0,22 eV du bord de la bande de valence dans le cas d'un super-réseau utilisant un isolant chargé positivement.

On obtient donc selon l'isolant utilisé un super-réseau se comportant comme une couche de type P ou comme une couche de type N et sans qu'aucun dopage soit utilisé. On dit qu'on a un dopage par charge d'espace. La suppression des matériaux dopés permet de réduire énormément le nombre de défauts.

Il faut noter qu'en modifiant l'épaisseur des couches de semiconducteur et en conservant constante l'épaisseur des couches d'isolant, les super-réseaux se comportent comme des matériaux de type P ou de type N, dont le dopage peut être modifié.

Les figures 4a et 4b sont des schémas de bande correspondant à la photodiode de la figure 2.

La figure 4a concerne le cas d'une photodiode qui ne reçoit pas de polarisation et la figure 4b le cas d'une photodiode qui est polarisée en inverse.

De gauche à droite, on a représenté en abscisse l'état des couches N, I et P. La bande de conduction $E_c$, le niveau de Fermi $E_F$ et la bande de valence $E_v$ sont représentés en ordonnées.

Pour la couche intrinsèque en silicium amorphe non dopé, le niveau de Fermi $E_F$ est à peu près à 0,72 eV du bord de la bande de conduction.

Sur la figure 4b, la position des niveaux de Fermi obtenue lorsque la photodiode est polarisée en inverse montre que l'on obtient un effet redresseur. On constate que le décalage des niveaux de Fermi entre la zone P et la zone N égale q.V, avec q, la charge de l'électron et V la tension de polarisation en inverse.

Un autre avantage des super-réseaux, pour les faibles épaisseurs des couches de semiconducteur, est l'augmentation de la bande interdite résultante par rapport à celle du silicium amorphe hydrogéné. Le coefficient d'absorption optique, à longueur d'onde égale, est plus faible dans le cas d'un super-réseau que pour du silicium amorphe massif.

En conséquence, la transparence est meilleure pour les photodiodes PIN selon l'invention qui utilisent des super-réseaux que pour les photodiodes PIN de l'Art Antérieur, ce qui permet d'étendre la réponse spectrale vers le bleu.

Il est donc possible d'éclairer les photodiodes selon l'invention par l'un ou l'autre de leurs côtés sans modification de structure ou des deux côtés, comme cela est représenté sur la figure 2. Il n'est plus utile comme dans l'Art Antérieur d'utiliser du carbure de silicium amorphe à la place du silicium amorphe pour améliorer la transmission des photons bleu-vert et permettre leur absorption dans la couche de silicium intrinsèque.

La figure 5 représente une vue en coupe d'un mode de réalisation d'une photodiode PIN selon l'invention qui diffère du mode de réalisation de la figure 2 car la couche intrinsèque I est également constituée par un super-réseau du même type que les super-réseaux constituant les couches de type P et de type N.

La couche intrinsèque I est donc constituée par un super-réseau de composition, avec des couches superposées de semiconducteur amorphe et d'isolant amorphe ou non, non dopées.

Dans le mode de réalisation de la figure 5, le super-réseau constituant la couche intrinsèque comporte 22 périodes $I_1$ à $I_{22}$. Chaque période est constituée d'une couche 12 d'isolant amorphe, par exemple de formule $a - Si_y N_x : H$, de 10nm d'épaisseur environ et d'une couche 13 de semiconducteur amorphe par exemple du silicium amorphe hydrogéné, de 80 nm d'épaisseur environ.

Une couche 11 en silicium amorphe hydrogéné assure la transition entre les zones P et I. Son épaisseur peut varier entre 1 et 10 nm. Entre les zones I et N, il n'y a pas de couches de transition car l'on suppose que les zones P et N ont la même nature que dans l'exemple de la figure 2, et dans ce cas l'isolant 9 de la zone N a la même nature que l'isolant 12 de la zone I.

L'intérêt de la structure de la figure 5 est qu'elle permet de modifier la capacité des photodiodes, par rapport à l'Art Antérieur.

On désigne par $L_S$ l'épaisseur des couches de semiconducteur, par $L_I$ l'épaisseur des couches d'isolant utilisées dans le super-réseau constituant la couche intrinsèque I. On désigne par $\epsilon_S$ et $\epsilon_I$ les permittivités du semiconducteur et de l'isolant.

Un effet des super-réseaux est qu'il produisent une anisotropie de la permittivité résultante c'est-à-dire que la permittivité perpendiculairement au plan des couches, $\epsilon_\perp$, est différente de la permittivité dans le sens parallèle au plan des couches, $\epsilon_\parallel$.

L'expression de ces permittivités est la suivante :

$$\epsilon_\parallel = (L_S + L_I) . \epsilon_S . \epsilon_I . (\epsilon_S L_I + \epsilon_I L_S)^{-1}$$
$$\epsilon_\perp = (L_I \epsilon_I + L_S \epsilon_S) . (L_I + L_S)^{-1}$$

A titre d'exemple, pour une épaisseur $L_S = 80$ nm et $L_I = 10$ nm, avec $\epsilon_S \simeq 10$ et $\epsilon_I \simeq 3,9$, on a $\epsilon_\perp = 7$, avec une résistivité à peu près conservée de l'ordre de $10^9 \Omega cm$.

Cette modification de la permittivité $\epsilon_\perp$ permet de réduire la capacité des photodiodes PIN selon l'invention.

En effet, la capacité d'une photodiode en déplétion totale dépend essentiellement des caractéristiques de sa couche intrinsèque, et plus précisément de la permitivité $\epsilon_\perp$ de sa couche intrinsèque.

Dans les photodiodes selon l'invention, il est possible que les couches P et N lorsqu'elles sont réalisées par des super-réseaux constitués par des couches non dopées, interviennent dans la capacité de la photodiode en déplétion. Cela se traduit par une plus grande diminution de la capacité.

Dans cas d'une photodiode de 100 × 100 micromètres carrés, dont la couche intrinsèque est en silicium amorphe massif, d'épaisseur 2 um, la capacité est de 1,8 picofarad. Si l'on utilise une photodiode de même surface, dont la couche intrinsèque a la même épaisseur mais se trouve constituée par un super-réseau de 22 périodes tel que celui décrit précédemment, la capacité n'est plus que de 1,2 picofarad.

Dans le cas d'un dispositif matriciel comportant 1000 diodes en parallèle, la capacité de l'ensemble est de 1,2 nanofarad lorsqu'on utilise des super-réseaux, alors qu'elle est de 1,8 nanofarad avec les photodiodes de l'Art Antérieur.

L'invention permet donc de diminuer de façon sensible la capacité des photodiodes PIN ce qui améliore leur utilisation dans des dispositifs matriciels.

Il est possible de diminuer encore la capacité des photodiodes PIN selon l'invention en réalisant la couche intrinsèque en empilant plusieurs super-réseaux de permittivité $\epsilon_\perp$ différente.

L'utilisation d'un super-réseau pour réaliser la couche intrinsèque permet éventuellement, si on le désire, d'augmenter la capacité des photodiodes. Il faut alors utiliser des couches isolantes dont la permittivité $\epsilon_I$ est élevée, c'est le cas par exemple de l'oxyde de titane amorphe.

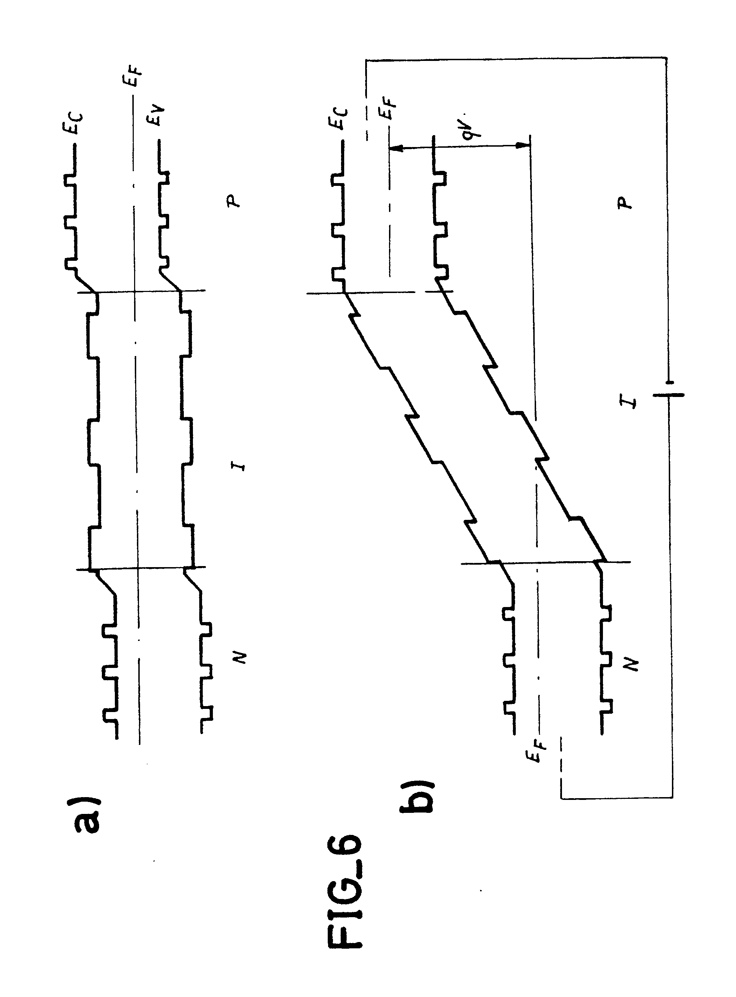

Comme les figures 4a et 4b, les figures 6a et 6b sont des schémas de bande relatifs à la photodiode de la figure 5. La figure 6a concerne les cas où la photodiode ne reçoit pas de polarisation et la figure 6b concerne le cas où la photodiode est polarisée en inverse.

Comme la figure 4b, la figure 6b montre que l'on obtient un effet redresseur lorsque la photodiode est polarisée en inverse.

Les figures 2 et 5 illustrent deux modes de réalisation de l'invention dans lesquels respectivement les couches P et N, et les couches P, I, N sont réalisées par des super-réseaux.

Il est bien entendu que l'invention concerne les photodiodes PIN dont au moins l'une des couches P, I, N est réalisée par un super-réseau de composition, constitué de couches superposées de semiconducteur amorphe et d'isolant, non dopées. La ou les couches qui ne sont pas réalisée par des super-réseaux sont réalisées en semiconducteur amorphe massif.

L'invention couvre donc les modes de réalisation où seule une des couches P, I ou N est en super-réseau, ainsi que les modes de réalisation où seules les couches P et I ou N et I sont en super-réseaux.

Les photodiodes PIN selon l'invention peuvent être utilisées dans les cellules solaires montées par exemple sur calculatrices. L'intérêt de l'invention est que ces cellules solaires peuvent être éclairées par leurs deux faces, ce qui accroît leur efficacité.

Les photodiodes selon l'invention peuvent être utilisées dans les barrettes de détecteurs, destinées à la télécopie.

Enfin, elles peuvent être utilisées pour la détection des rayons X, que ce soit pour la surveillance des bagages ou dans le domaine de la radiographie médicale.

Dans ces utilisations, elles sont précédées par un scintillateur qui convertit le rayonnement X en rayonnement visible. On connait des scintillateurs fournissant un rayonnement de 550 nm de longueur d'onde environ, que le silicium amorphe est tout à fait apte à détecter.

## Revendications

1. Photodiode PIN réalisée à partir de semiconducteur amorphe, comportant trois couches superposées qui sont une couche de type P, une couche intrinsèque (I) et une couche de type N, caractérisée en ce qu'au moins l'une de ces couches est constituée par un super-réseau de composition, comportant des couches superposées de semiconducteur amorphe et d'isolant, non dopées, et en ce que le ou les autres couches sont réalisées en semiconducteur amorphe.

2. Photodiode selon la revendication 1, caractérisée en ce que la couche de type P est réalisée par un super-réseau de composition, constitué par la superposition de couches non dopées de semiconducteur amorphe (7) et d'isolant (8), chargé positivement.

3. Photodiode selon la revendication 2, caractérisée en ce que l'isolant (8) chargé positivement a la formule suivante : Si $C_x$ avec $x > 0,5$ ou Si $O_x$ avec $x \leq 2$.

4. Photodiode selon l'une des revendications 1 à 3, caractérisée en ce que la couche de type N est réalisée par un super-réseau de composition constitué par la superposition de couches non dopées, de semiconducteur amorphe (10) et d'isolant (9), chargé négativement.

5. Photodiode selon la revendication 4, caractérisée en ce que l'isolant (9) chargé négativement a la formule suivante : $Si_y N_x$, avec $x \leq 4$ et $y \leq 3$ ou $Al_x O_y$ avec $x \leq 2$ et $y \leq 3$.

6. Photodiode selon l'une des revendications 1 à 5, caractérisée en ce que le semiconducteur (7, 10, 13) est du silicium, du germanium, un matériau de type III - V, ou un chalcogénure.

7. Photodiode selon l'une des revendications 1 à 6, caractérisée en ce qu'il s'agit d'un semiconducteur amorphe hydrogéné.

8. Photodiode selon l'une des revendications 1 à 7, caractérisée en ce qu'il s'agit d'isolant amorphe hydrogéné.

**Claims**

1. A PIN photodiode produced from amorphous semiconductor, comprising three superposed layers which are a P type layer, an intrinsic layer (I) and an N type layer, characterized in at least one of the layers is constituted by a multi layer composition, comprising undoped superposed layers of amorphous semiconductor and of insulating material and in that the other layer or layers is made of amorphous semiconductor.

2. The photodiode as claimed in claim 1, characterized in that the P type layer is formed of a multi layer composition constituted by the superposition of undoped layers of amorphous semiconductor (7) and of insulating material with a positive charge.

3. The photodiode as claimed in claim 2, characterized in that the insulating material (8) with a positive charge has the following formula: $SiC_x$ wherein $x > 0.5$ or SiOx with $x \leq 2$.

4. The photodiode as claimed in any one of the preceding claims 1 through 3, characterized in that the type N layer is in the form of multi layer composition constituted by the superposition of undoped layers of amorphous semiconductor (10) and insulating material (9) with a negative charge.

5. The photodiode as claimed in claim 4, characterized in that the insulating material (9) with a positive charge has the following formula: $Si_yN_x$ with $X \leq 4$ and $y \leq 3$ or $Al_xO_y$ wherein $x \leq 2$ and $y \leq 3$.

6. The photodiode as claimed in any one of the preceding claims 1 through 5, characterized in that the semiconductor is silicon, germanium, a type III- V material or a chalcogenide.

7. The photodiode as claimed in any one of the preceding claims 1 through 6, characterized in that it is a question of an amorphous hydrogenated semiconductor.

8. The photodiode as claimed in any one of the preceding claims 1 through 7, characterized in that it is a question of an amorphous hydrogenated insulating material.

**Patentansprüche**

1. PIN-Photodiode, ausgebildet aus einem amorphen Halbleiter, der drei übereinanderliegende Schichten umfaßt, die eine Schicht von P-Typ, eine Intrinsic-Schicht (I) und eine Schicht von N-Typ sind, dadurch gekennzeichnet, daß wenigstens eine dieser Schichten aus einer zusammengesetzten Vielschichtstruktur besteht, die nicht dotierte, übereinanderliegende Schichten aus einem amorphen Halbleiter und einem Isoliermaterial umfaßt, und daß die andere Schicht oder die anderen Schichten aus einem amorphen Halbleiter besteht bzw. bestehen.

2. Photodiode nach Anspruch 1, dadurch gekennzeichnet, daß die Schicht vom P-Typ durch eine zusammengesetzte Vielschichtstruktur gebildet ist, die durch das Übereinanderliegen nicht dotierter Schichten eines amorphen Halbleiters (7) und eines Isoliermaterials (8), das positiv geladen ist, gebildet ist.

3. Photodiode nach Anspruch 2, dadurch gekennzeichnet, daß das positiv geladene Isoliermaterial (8) die folgende Formel aufweist: Si $C_x$ mit $x > 0,5$ oder Si $O_x$ mit $x \leq 2$.

4. Photodiode nach einem der Ansprüche 1 bis 3, dadurch gekennzeichnet, daß die Schicht vom N-Typ durch eine zusammengesetzte Vielschichtstruktur gebildet ist, die durch das Übereinanderliegen nicht dotierter Schichten eines amorphen Halbleiters (10) und eines Isoliermaterials (9), das negativ geladen ist, gebildet ist.

5. Photodiode nach Anspruch 4, dadurch gekennzeichnet, daß das negativ geladene Isoliermaterial (9) die folgende Formel aufweist: $Si_y N_x$, mit $x \leq 4$ und $y \leq 3$ oder $Al_x O_y$ mit $x \leq 2$ und $y \leq 3$.

6. Photodiode nach einem der Ansprüche 1 bis 5, dadurch gekennzeichnet, daß der Halbleiter (7, 10, 13) aus Silizium, Germanium, einem Material vom Typ III-V oder aus Chalcogenid besteht.

7. Photodiode nach einem der Ansprüche 1 bis 6, dadurch gekennzeichnet, daß es sich um einen wasserstoffangereicherten, amorphen Halbleiter handelt.

8. Photodiode nach einem der Ansprüche 1 bis 7, dadurch gekennzeichnet, daß es sich um ein wasserstoffangereichertes, amorphes Isoliermaterial handelt.

FIG_1

FIG_2

FIG_3

FIG_4

# FIG_5

FIG_6